# DEMANDE DE BREVET EUROPEEN

(11) **EP 2 451 258 A1**
(43) Date de publication de la demande: **09.05.2012**
(21) Numéro de dépôt: 10190243.5
(22) Date de dépôt: 05.11.2010
(51) Int. Cl.: H05K 3/40, G02F 1/13, G02F 1/1345

(54) **Ensemble formé d'au moins deux dispositifs électroniques à couches actives superposés et moyens pour la connexion électrique de ces deux dispositifs à un circuit électronique de commande**

(71) Demandeur: The Swatch Group Research and Development Ltd., 2074 Marin (CH)
(72) Inventeur: Burri, Yves, 1066, Epalinges (CH); Springer, Simon, 3007, Bern (CH)
(74) Mandataire: Ravenel, Thierry Gérard Louis

(57) **Abrégé**

Ensemble formé d'au moins deux dispositifs électroniques, par exemple des cellules d'affichage à cristal liquide superposées (36, 40), chacune de ces deux cellules (36, 40) étant délimitée par deux substrats (22, 24, 26, 28) réunis et maintenus à distance constante l'un de l'autre par un cadre de scellement, au moins une électrode et une contre-électrode correspondante étant structurées sur les faces en regard des substrats (22, 24, 26, 28), les électrodes venant à l'une de leurs extrémités affleurer le rebord du substrat (22, 24, 26, 28) sur lequel elles sont structurées, des premières et deuxièmes pistes conductrices (37, 39) reliant les électrodes aux ports d'un circuit électronique de commande (30) monté sur le dos (32) du dispositif d'affichage (20), les premières pistes conductrices (37) s'étendant d'abord parallèlement aux deuxièmes pistes conductrices (39) puis s'élargissant et passant sous ces deuxièmes pistes conductrices (39) à l'endroit où ces deuxièmes pistes conductrices (39) s'interrompent.

## Description

La présente invention concerne un système électronique comprenant au moins deux dispositifs électroniques à couches actives superposés et des moyens pour la connexion électrique de ces deux dispositifs à un circuit électronique de commande. En particulier, la présente invention concerne un tel système électronique comprenant une cellule d'affichage délimitant un volume pour le confinement d'un fluide tel qu'un cristal liquide et, plus généralement, d'une matière sensible susceptible de changer de propriétés optiques sous l'effet de l'application d'une tension ou d'un courant, cette cellule d'affichage étant préférentiellement disposée au-dessus d'un deuxième dispositif électronique à couche active pouvant être choisi dans le groupe formé par les cellules d'affichage à cristal liquide, les réseaux matriciels de diodes électroluminescentes et les cellules photovoltaïques à fortes densités de lignes.

Dans son acception la plus simple, une cellule à cristal liquide se compose pour l'essentiel d'un substrat avant transparent et d'un substrat arrière également transparent ou non, ces deux substrats étant réunis et maintenus à distance constante l'un de l'autre par un cadre de scellement qui délimite un volume étanche pour le confinement du cristal liquide. Par ailleurs, les substrats avant et arrière comportent chacun, sur leurs faces en regard, au moins une électrode, ces électrodes étant destinées à être reliées à un circuit électronique de commande qui, par application sélective de tensions appropriées à des électrodes déterminées, permet de modifier les propriétés optiques du cristal liquide au point de croisement des électrodes considérées.

Un problème constant dans le domaine de la fabrication des cellules à cristaux liquides du genre décrit ci-dessus est posé par les moyens de connexion destinés à établir la liaison électrique entre les électrodes de la cellule et le circuit de commande de cette cellule. Une technique simple pour procéder à la connexion électrique entre les électrodes et le circuit de commande de la cellule consiste à décaler les substrats l'un par rapport à l'autre, si bien que l'on peut accéder à une partie des électrodes qui émergent de la cellule au niveau de la surface ainsi dégagée et réaliser aisément les connexions. Un tel agencement des substrats rend cependant la fabrication des cellules en série difficile, notamment lorsque celles-ci sont circulaires, et nécessite des opérations supplémentaires coûteuses en temps. Les cellules résultantes sont, en outre, de plus grandes dimensions et donc difficiles à loger dans des objets électroniques portatifs de petites dimensions tels qu'une montre-bracelet. Par ailleurs, la zone nécessaire aux contacts est considérée comme une zone perdue car elle ne peut être utilisée pour afficher une information. Pour un encombrement donné, ceci réduit donc la zone utile d'affichage.

Une autre solution au problème susmentionné a été proposée par la Demanderesse dans la demande internationale publiée sous le numéro WO 99/41638. On connaît, en effet, par cette demande, une cellule électro-optique telle qu'une cellule à cristal liquide, ou une cellule photovoltaïque électrochimique, ces cellules se composant chacune d'un substrat avant transparent, d'un substrat arrière également transparent ou non, un cadre de scellement réunissant les deux substrats et définissant un volume pour le confinement étanche d'un milieu actif photoélectrique ou électro-optique, les substrats comportant sur leurs faces en regard au moins une électrode. Ces cellules se distinguent par le fait que leurs électrodes viennent, à l'une de leurs extrémités, affleurer le bord du substrat sur lequel elles sont structurées pour définir des zones de contact électrique à hauteur desquelles sont rapportées des pièces en forme d'équerre qui permettent avantageusement de reporter le contact électrique sur la face arrière desdites cellules.

Grâce à ces caractéristiques, il n'est plus nécessaire de prévoir de décalage entre les deux substrats d'une cellule pour pouvoir établir la connexion électrique entre les électrodes de la cellule et le circuit de commande de celle-ci, de sorte que ces substrats peuvent présenter des dimensions identiques et être disposés l'un au dessus de l'autre à recouvrement. On aboutit ainsi à une plus grande simplicité de fabrication de cellules de formes originales et variées, et donc à une diminution sensible du prix de revient de ce type de cellules. D'autre part, l'encombrement des cellules est réduit, ce qui facilite leur montage notamment dans une pièce d'horlogerie.

La solution décrite ci-dessus présente cependant un inconvénient. En effet, les pièces de contact électrique, réalisées en métal ou en un alliage métallique conducteur de l'électricité, constituent des éléments discrets qu'il est nécessaire de coller les uns après les autres au moyen d'une colle conductrice sur la tranche de la cellule, aux endroits où les électrodes affleurent le bord du substrat sur lequel elles sont disposées. Un tel procédé de fabrication, s'il s'avère relativement simple à mettre en oeuvre dans le cas d'une cellule photovoltaïque électrochimique qui ne comporte que deux électrodes, s'avère beaucoup plus compliqué à utiliser dans le cas des cellules à cristal liquide qui, lorsqu'elles sont de type matriciel, peuvent comporter plusieurs centaines d'électrodes et de contre-électrodes auxquelles il faudrait, à chaque fois, associer une pièce de report du contact électrique. Bien entendu, le procédé de fabrication pourrait être automatisé, mais le nombre et la précision avec laquelle les pièces de contact électrique devraient être rapportées sur la tranche des cellules renchériraient considérablement les coûts de fabrication de telles cellules.

Comme illustré sur les figures 1 à 3 annexées à la présente demande de brevet, une autre solution consiste à structurer par toute technique appropriée de dépôt et de gravure de couches conductrices permettant d'atteindre les dimensions et la résolution recherchée, des pistes conductrices sur la tranche et la face arrière d'une cellule à cristal liquide.

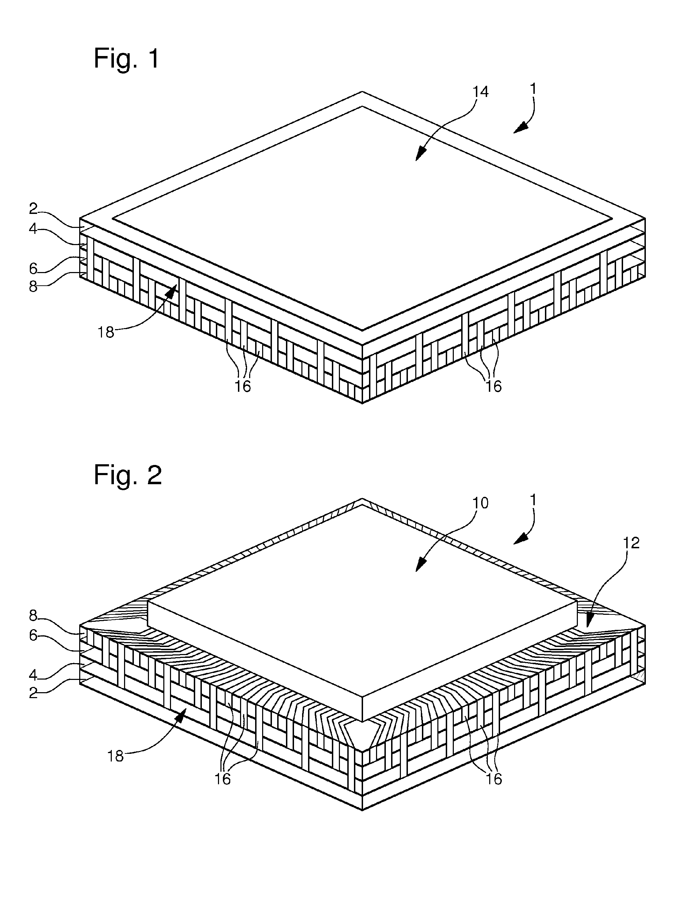

Les figures 1 et 2 sont des vues en perspective, respectivement à l'endroit et à l'envers, d'un empilement de cellules d'affichage à cristaux liquides. Désigné dans son ensemble par la référence numérique générale 1, cet empilement de cellules d'affichage comprend quatre substrats superposés 2, 4, 6 et 8 qui peuvent être réalisés en verre ou en un autre matériau transparent tel que du plastique. On notera que le dernier substrat 8 peut être transparent ou non selon la nature réflective ou transmissive de l'empilement 1 de cellules d'affichage. Dans le cas présent, comme un circuit électronique 10 de commande de l'affichage de l'empilement 1 de cellules est monté sur le dos 12 dudit empilement 1 (voir figure 2), on a affaire à un empilement de cellules de type réflectif et le substrat arrière 8 pourra être opaque ou recouvert d'une couche d'un matériau opacifiant afin de masquer le circuit électronique 10 à la vue d'un observateur situé du côté avant 14 de l'empilement 1 de cellules.

Les substrats 2 à 8 sont réunis deux à deux par des cadres de scellement (non visibles sur les figures 1 et 2) qui délimitent chacun une cavité étanche pour le confinement des cristaux liquides. Plus précisément, un premier cadre de scellement réunit les substrats 2 et 4, tandis qu'un second cadre de scellement réunit les substrats 4 et 6 et qu'un troisième et dernier cadre de scellement réunit les substrats 6 et 8.

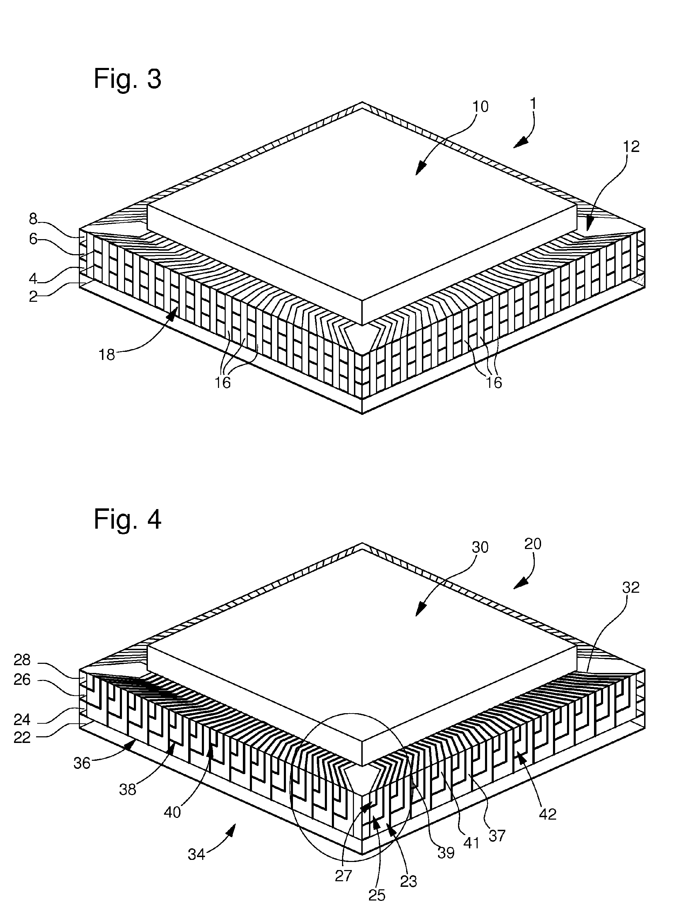

Les électrodes de l'empilement de cellules 1 viennent affleurer par une de leurs extrémités un des rebords du substrat sur lequel elles ont été structurées pour y définir des zones de contact électrique latérales. Des pistes conductrices 16 qui viennent en contact avec les électrodes au niveau des zones de contact électrique latérales sont formées directement sur la tranche 18 et le dos 12 de l'empilement de cellules 1, de façon à reporter tous les contacts électriques dans le même plan arrière dudit empilement 1. Les pistes conductrices 16 s'étendent donc depuis les électrodes de l'empilement de cellules 1 jusqu'aux ports du circuit électronique 10 de commande de l'affichage qui est monté sur le dos 12 de l'empilement 1. Sur les figures 1 et 2, on voit que les pistes conductrices ne sont pas de longueurs égales et s'arrêtent juste aux endroits où les électrodes viennent affleurer la tranche 18 de l'empilement de cellules 1. II va de soi que les pistes conductrices 16 ont été ainsi représentées afin de mieux faire comprendre la façon dont les connexions électriques s'établissent entre les électrodes et lesdites pistes conductrices 16 mais que, dans la pratique, on préférera réaliser des pistes conductrices 16 de longueurs identiques comme illustré à la figure 3.

Grâce à ces caractéristiques, les substrats des cellules d'affichage peuvent être de dimensions sensiblement égales et ne nécessitent plus d'être décalés l'un par rapport à l'autre pour permettre l'établissement des connexions électriques entre les électrodes et le circuit de commande. Ainsi, si, pour de mêmes dimensions externes, la surface active d'une cellule à cristal liquide peut être augmentée, on peut augmenter la résolution de l'afficheur, c'est-à-dire prévoir un nombre plus important d'électrodes de lignes et de colonnes, sans que l'ouverture des pixels, et donc la réflectivité de la cellule d'affichage, ne soient altérées. Inversement, on peut mettre à profit l'augmentation de la surface active de la cellule d'affichage pour, à nombre constant d'électrodes de lignes et de colonnes, augmenter la largeur desdites électrodes et donc augmenter l'ouverture des pixels, ce qui a un effet favorable sur la réflectivité de l'afficheur.

Les moyens pour relier les électrodes d'une cellule d'affichage à un circuit de commande ne sont donc pas formés par des pièces de contact qu'il serait nécessaire de coller une à une, mais par des pistes conductrices qui permettent de reporter les contacts électriques formés par les électrodes d'une cellule depuis la tranche de la cellule jusqu'au bord arrière de ladite cellule, puis, de là, autour dudit bord arrière et jusque sur le dos de la cellule.

Pour former les pistes conductrices qui permettent de reporter les contacts électriques formés par les électrodes d'une cellule sur le dos de cette cellule, on procède de la façon suivante. Une fine couche de matériau conducteur est par exemple évaporée sur le dos et la tranche de la cellule au moyen d'une source d'évaporation d'un matériau électriquement conducteur.

Après métallisation du dos et de la tranche des cellules, il faut structurer les pistes conductrices, par exemple par ablation laser. Par souci d'économie et afin d'obtenir un meilleur rendement, on peut envisager que seules les premières parties des pistes conductrices qui s'étendent sur la tranche des cellules à cristal liquide soient structurées par ablation laser, tandis que les secondes parties de ces mêmes pistes conductrices qui s'étendent au dos des cellules pourront être structurées par des techniques de photolithographie classiques.

Comme on l'aura compris de ce qui précède, la jonction électrique entre les électrodes d'une cellule à cristal liquide et les pistes conductrices qui permettent de reporter les contacts électriques formés par les électrodes de la cellule jusqu'aux ports du circuit électronique de commande de l'affichage monté par exemple sur le dos de cette cellule se fait dans la zone de contact électrique latérale où les électrodes affleurent le rebord du substrat sur lequel elles ont été structurées. Par conséquent, la surface de contact entre une électrode et la piste conductrice correspondante est sensiblement égale à la section d'une telle électrode. Une telle surface de contact est très faible mais néanmoins suffisante pour assurer la jonction électrique entre les électrodes et les pistes conductrices. Toutefois, pour augmenter la surface de contact entre les électrodes et les pistes conductrices, il est possible de déposer sur les extrémités des électrodes qui affleurent le rebord du substrat sur lequel ces électrodes ont été déposées des plots de matière conductrice qui ont pour effet d'augmenter la surface de contact électrique entre les électrodes et les pistes conductrices. On rend ainsi la connexion électrique entre les électrodes et les pistes conductrices plus fiable encore.

On constate à l'examen de la figure 3 mentionnée ci-dessus que les pistes conductrices sont toutes de mêmes dimensions et s'étendent parallèlement entre elles. Par conséquent, pour éviter autant que possible les risques de mauvais contacts ou de courts-circuits, les électrodes, le cas échéant les plots conducteurs et les pistes conductrices doivent tous être réalisés avec une précision élevée, ce qui ralentit les cadences de production et renchérit le prix de revient des cellules d'affichage.

La présente invention a pour but de pallier ces inconvénients ainsi que d'autres encore en procurant un dispositif d'affichage délimitant un volume pour le confinement d'un fluide tel qu'un cristal liquide et, plus généralement, d'une matière sensible susceptible de changer de propriétés optiques sous l'effet de l'application d'une tension ou d'un courant électriques, comprenant des moyens pour sa connexion à un circuit électronique de commande permettant de garantir une connexion électrique fiable tout en exigeant une précision de fabrication moindre.

A cet effet, la présente invention concerne un système électronique délimité par une face avant située du côté d'un observateur, une face arrière s'étendant parallèlement à la face avant et une surface latérale reliant les faces avant et arrière, ce système électronique comprenant au moins un dispositif électronique supérieur et un dispositif électronique inférieur superposés, chaque dispositif comprenant un substrat avant et un substrat arrière s'étendant parallèlement et à distance l'un de l'autre, le substrat arrière du dispositif électronique supérieur pouvant être commun avec le substrat avant du dispositif électronique inférieur, le substrat arrière du dispositif électronique inférieur pouvant être omis, le dispositif électronique supérieur comprenant une première couche active disposée entre le substrat avant et le substrat arrière, la première couche active étant commandée par au moins une première électrode et une première contre-électrode correspondante structurées sur les faces en regard des substrats avant et arrière, la première électrode et la première contre-électrode du dispositif électronique supérieur étant reliées par des premières pistes conductrices à un circuit électronique de commande monté sur la face arrière du système électronique, la première électrode et la première contre-électrode venant affleurer à une de leurs extrémités le bord du substrat sur lequel elles sont structurées pour définir des premières zones latérales de contact électrique, les premières pistes conductrices s'étendant depuis les premières zones latérales de contact électrique vers la face arrière du système électronique, le dispositif électronique inférieur comprenant une deuxième couche active disposée entre le substrat avant et le substrat arrière du dispositif électronique inférieur, la deuxième couche active étant commandée par au moins une deuxième électrode et une deuxième contre-électrode correspondante structurées sur les faces en regard des substrats avant et arrière, la deuxième électrode et la deuxième contre-électrode du dispositif électronique inférieur étant reliées par des deuxièmes pistes conductrices au circuit électronique de commande monté à l'arrière du système électronique, la deuxième électrode et la deuxième contre-électrode venant affleurer à une de leurs extrémités le bord du substrat sur lequel elles sont structurées pour définir des deuxièmes zones latérales de contact électrique, les deuxièmes pistes conductrices s'étendant depuis les deuxièmes zones latérales de contact électrique vers la face arrière du système électronique, les premières zones latérales de contact électrique du dispositif électronique supérieur étant alignées selon une direction parallèle à la direction d'alignement des deuxièmes zones latérales de contact électrique du dispositif électronique inférieur, le système électronique étant caractérisé en ce qu'en considérant dans le sens de gauche à droite selon les deux directions d'alignement parallèles l'une des premières zones latérales de contact électrique du dispositif électronique supérieur et l'une des deuxièmes zones latérales de contact électrique du dispositif électronique inférieur la plus proche de la première zone latérale de contact électrique, la première piste conductrice qui relie la première zone latérale de contact électrique du dispositif électronique supérieur au circuit électronique de commande comprend une première portion qui est adjacente à la deuxième piste conductrice qui relie la deuxième zone latérale de contact électrique du dispositif électronique inférieur au circuit de commande et qui est prolongée par une seconde portion qui s'étend au-dessous de la deuxième piste conductrice.

Grâce à ces caractéristiques, la présente invention procure un système électronique comprenant au moins deux dispositifs électroniques superposés dont les électrodes et les contre-électrodes correspondantes peuvent être reliées à un circuit électronique de commande au moyen de pistes conductrices plus larges. La zone de contact électrique entre une électrode donnée et la piste conductrice associée à l'endroit où l'électrode affleure le bord du substrat sur lequel elle a été déposée présente ainsi une surface plus importante que dans l'art antérieur, ce qui permet d'élargir les électrodes, de réduire les exigences d'alignement de ces électrodes et d'autoriser un alignement moins précis des moyens de structuration des pistes conductrices tels qu'un faisceau laser. De ce fait, les risques de mauvais contact ou de court-circuit sur la tranche de la cellule où affleurent les électrodes sont limités et le temps nécessaire à aligner les divers éléments constituant le système électronique selon l'invention au cours des différentes étapes de fabrication est réduit. On obtient ainsi un système électronique plus fiable tout en pouvant être fabriqué dans un laps de temps plus court, ce qui permet de réduire le prix de revient d'un tel système électronique.

Selon une caractéristique complémentaire de l'invention, on dépose sur l'extrémité des électrodes qui affleurent le bord du substrat sur lequel elles ont été structurées un plot de matière conductrice pour augmenter davantage encore la surface de contact entre les électrodes et les pistes conductrices.

Selon une autre caractéristique de l'invention, le premier dispositif électronique est une cellule d'affichage à cristal liquide et le second dispositif électronique est choisi dans le groupe formé par les cellules d'affichage à cristal liquide, les réseaux matriciels de diodes électroluminescentes et les cellules photovoltaïques à fortes densités de lignes.

D'autres caractéristiques et avantages de la présente invention ressortiront plus clairement de la description détaillée qui suit d'un mode de réalisation d'un dispositif d'affichage selon l'invention, cet exemple étant donné à titre purement illustratif et non limitatif seulement en liaison avec le dessin annexé sur lequel:
- la figure 1, déjà citée, est une vue générale en perspective à l'endroit d'un dispositif d'affichage à cristal liquide multicouches selon l'art antérieur;
- la figure 2, déjà citée, est une vue générale en perspective à l'envers du dispositif d'affichage multicouches représenté à la figure 1 ;
- la figure 3, déjà citée, est une vue identique à celle de la figure 2, la seule différence résidant dans le fait que les pistes conductrices qui permettent de relier les électrodes au circuit électronique de commande sont toutes de même longueur;
- la figure 4 est une vue générale en perspective à l'envers d'un dispositif d'affichage à cristal liquide selon l'invention, ce dispositif d'affichage comprenant trois cellules à cristal liquide superposées, les pistes conductrices de deuxième niveau permettant de relier les électrodes de la cellule à cristal liquide intermédiaire au circuit électronique de commande s'élargissant aux endroits où les pistes conductrices de troisième niveau permettant de relier les électrodes de la cellule à cristal liquide inférieure au circuit électronique de commande s'interrompent, et les pistes conductrices de premier niveau permettant de relier les électrodes de la cellule à cristal liquide supérieure au circuit de commande s'élargissant aux endroits où les pistes conductrices de deuxième niveau s'interrompent;
- la figure 5 est une vue de détail à plus grande échelle de la région entourée d'un cercle sur la figure 4;
- la figure 6 est une vue partielle en transparence du dispositif d'affichage à cristal liquide selon l'invention;
- la figure 7 est une vue schématique en coupe d'un système électronique selon l'invention comprenant une cellule d'affichage à cristal liquide disposée au-dessus d'un réseau matriciel de diodes électroluminescentes pour l'éclairage de la cellule d'affichage;
- la figure 8 est une vue schématique en coupe d'un système selon l'invention comprenant une cellule d'affichage à cristal liquide disposée au-dessus d'une cellule photovoltaïque à forte densité pour l'alimentation de la cellule d'affichage, et
- la figure 9 est une vue schématique en coupe d'un système électronique selon l'invention comprenant une cellule d'affichage à cristal liquide, un réseau matriciel de diodes électroluminescentes et une cellule photovoltaïque à forte densité disposés les uns au-dessus des autres.

La présente invention procède de l'idée générale inventive qui consiste à structurer de manière optimale les pistes conductrices qui permettent de relier à un circuit électronique de commande les électrodes d'une cellule d'affichage par exemple à cristal liquide appartenant à un empilement d'au moins deux telles cellules d'affichage. Dans l'art antérieur, les pistes conductrices qui permettaient de relier les électrodes de chacune des cellules d'affichage à cristal liquide d'un empilement d'au moins deux telles cellules étaient toutes parallèles entre elles et de même longueur. En particulier, les pistes conductrices qui permettaient de relier au circuit électronique de commande les électrodes de la cellule d'affichage de niveau le plus bas dans l'empilement de telles cellules étaient de même longueur que les pistes conductrices qui permettaient de relier au circuit de commande les électrodes de la cellule d'affichage de niveau le plus haut. Une portion des pistes conductrices de niveau le plus bas était donc inutile et réduisait la surface disponible sur la tranche du dispositif d'affichage pour les autres pistes conductrices. La présente invention enseigne d'interrompre les pistes conductrices de niveau le plus bas dans la région où les électrodes de la cellule correspondante affleurent la tranche du substrat sur lequel elles ont été déposées, de manière à libérer de la place pour permettre aux pistes conductrices des niveaux plus élevés d'occuper une surface plus importante. Grâce à ces caractéristiques, on augmente la surface de contact entre les pistes conductrices et les électrodes aux endroits où celles-ci affleurent le bord du substrat sur lequel elles ont été déposées, ce qui permet de réduire les exigences sur l'alignement des électrodes de même que le temps nécessaire à la fabrication.

La figure 4 est une vue schématique en perspective et à l'envers d'un système électronique selon l'invention. Désigné dans son ensemble par la référence numérique générale 20, ce système électronique constitue, dans l'exemple représenté au dessin, un dispositif d'affichage comprenant quatre substrats superposés 22, 24, 26 et 28 qui peuvent être réalisés en verre ou en un autre matériau transparent tel que du plastique. Un circuit électronique 30 de commande de l'affichage est monté sur le dos 32 du dispositif d'affichage 20, c'est-à-dire du côté opposé à la face avant 34 où se situe l'observateur.

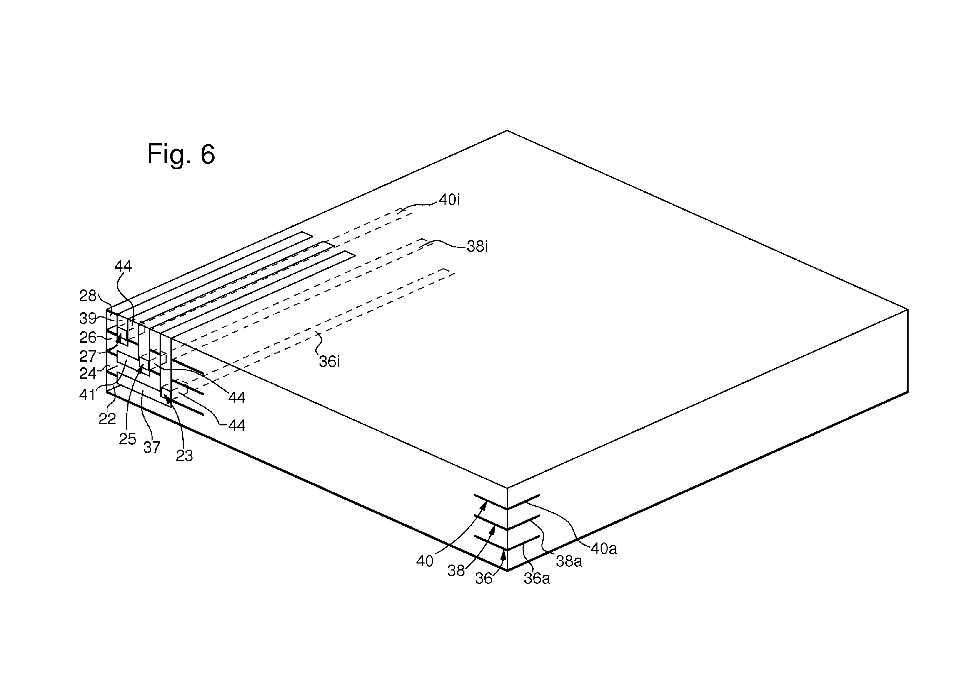

Réunis deux à deux par des cadres de scellement (non visibles sur la figure 4), les quatre substrats 22, 24, 26 et 28 délimitent trois dispositifs électroniques superposés, en l'occurrence trois cellules d'affichage hermétiquement closes dans lesquelles est confiné par exemple un cristal liquide. Plus précisément, sur la figure 6, les substrats 22 et 24 délimitent entre eux la cellule d'affichage supérieure 36 de niveau le plus haut, c'est-à-dire celle qui constitue la face d'entrée 34 du dispositif d'affichage 20 et qui comprend une couche active 36a de cristal liquide. Par suite, les substrats 24 et 26 délimitent entre eux la cellule d'affichage intermédiaire 38 qui comprend une couche active 38a de cristal liquide et les substrats 26 et 28 délimitent entre eux la cellule d'affichage inférieure 40 de niveau le plus bas, c'est-à-dire celle qui constitue le dos 32 du dispositif d'affichage 20 et qui comprend une couche active 40a de cristal liquide.

Des électrodes et des contre-électrodes correspondantes 36i, 38i et 40i (dont certaines sont visibles sur la figure 6) sont structurées sur les faces en regard des substrats 22 et 24, 24 et 26 et 26 et 28. Ces électrodes sont destinées à être reliées au circuit électronique de commande 30 qui, par application sélective de tensions appropriées à des électrodes déterminées, permet de modifier les propriétés optiques du cristal liquide au point de croisement des électrodes considérées.

Les électrodes des cellules d'affichage 36, 38 et 40 viennent affleurer par une de leurs extrémités un des rebords du substrat sur lequel elles ont été structurées pour y définir des zones de contact électrique latérales désignées respectivement par les références numériques 23, 25 et 27. Des premières, deuxièmes et troisièmes pistes conductrices 37, 39 et 41 qui viennent en contact avec les électrodes au niveau des zones de contact électrique latérales 23, 25 et 27 sont formées directement sur la tranche 42 et le dos 32 du dispositif d'affichage 20, de façon à reporter tous les contacts électriques dans le même plan arrière du dispositif d'affichage 20. Les pistes conductrices 37, 39 et 41 s'étendent donc depuis les électrodes du dispositif d'affichage 20 jusqu'aux ports du circuit électronique 30 de commande de l'affichage qui est monté sur le dos 32 du dispositif d'affichage 20.

Pour augmenter la qualité de la connexion électrique entre les électrodes et les pistes conductrices 37, 39 et 41, il est possible de déposer au bout des électrodes, dans les zones où celles-ci affleurent le bord du substrat sur lequel elles ont été déposées, des plots de matière conductrice 44 qui ont pour effet d'augmenter la surface de contact entre les électrodes et les pistes conductrices.

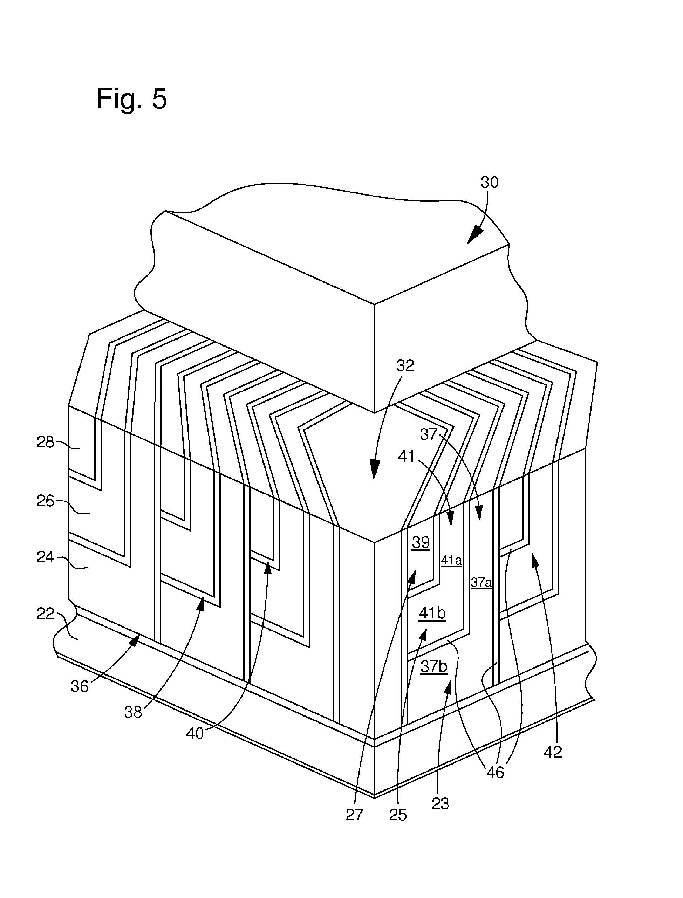

Comme on le voit à l'examen de la figure 4 et mieux encore sur la figure 5 qui correspond à une vue à plus grande échelle de la région entourée d'un cercle sur la figure 4, les deuxièmes pistes conductrices 39 qui permettent de relier les électrodes de la cellule d'affichage inférieure 40 de niveau le plus bas aux ports du circuit électronique 30 de commande de l'affichage monté sur le dos 32 du dispositif d'affichage 20 s'étendent depuis les zones de contact électrique 27 jusqu'à l'arrière du dispositif d'affichage 20. Dans le même temps, les troisièmes pistes conductrices 41 qui permettent de relier les électrodes de la cellule d'affichage intermédiaire 38 aux ports du circuit électronique 30 comprennent d'abord une première portion 41 a qui s'étend parallèlement aux deuxièmes pistes conductrices 39 puis une seconde portion 41 b qui s'élargit à l'endroit où ces deuxièmes pistes conductrices 39 s'interrompent en s'étendant sous ces deuxièmes pistes 39. Enfin, les premières pistes conductrices 37 qui permettent de relier les électrodes de la cellule d'affichage supérieure 36 de niveau le plus haut aux ports du circuit électronique de commande 30 comprennent d'abord une première portion 37a qui s'étend parallèlement aux deuxièmes et troisièmes pistes conductrices 39 et 41 puis une seconde portion 37b qui s'élargit à l'endroit où les troisièmes pistes conductrices s'interrompent.

Grâce à ces caractéristiques, la présente invention procure un dispositif d'affichage comprenant au moins deux cellules d'affichage superposées dont les électrodes sont reliées par des pistes conductrices aux ports d'un circuit électronique de commande, ces pistes conductrices présentant aux endroits où les électrodes affleurent la tranche du substrat sur lequel elles ont été structurées des surfaces de contact plus importantes. L'augmentation de la surface de contact entre une électrode donnée et la piste conductrice qui lui est associée permet d'élargir les électrodes, de réduire les exigences d'alignement de ces électrodes et d'autoriser un alignement moins précis des moyens de structuration des pistes conductrices tels qu'un faisceau laser. De ce fait, les risques de mauvais contact ou de court-circuit sur la tranche de la cellule où affleurent les électrodes sont limités et le temps nécessaire à aligner les divers éléments constituant le dispositif d'affichage selon l'invention au cours des différentes étapes de fabrication est réduit. On obtient ainsi un dispositif d'affichage pouvant être fabriqué dans un laps de temps plus court et avec un meilleur rendement, ce qui permet en outre de réduire le prix de revient d'un tel dispositif d'affichage. On observera que les pistes conductrices 37, 39 et 41 sont séparées les unes des autres par des interstices isolants 46 pour éviter les risques de court-circuit.

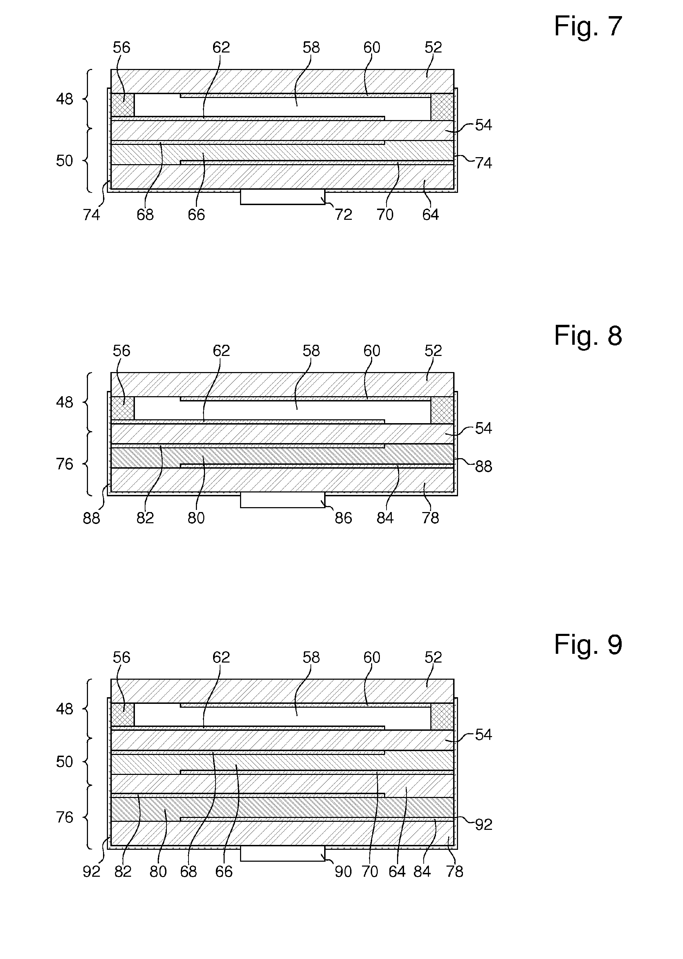

La figure 7 est une vue schématique en coupe d'un système électronique selon l'invention comprenant une cellule d'affichage à cristal liquide 48 disposée par exemple au-dessus d'un réseau matriciel de diodes électroluminescentes 50 pour l'éclairage de la cellule d'affichage 48. La cellule d'affichage à cristal liquide 48 est délimitée par un substrat avant 52 et par un substrat arrière 54 qui s'étend parallèlement à et à distance du substrat avant 52. Les substrats avant 52 et arrière 54 sont réunis entre eux par un cadre de scellement 56 qui délimite un volume étanche pour le confinement d'une couche active 58 de cristal liquide. Une pluralité d'électrodes 60 et de contre-électrodes 62 structurées sur les faces en regard des substrats avant 52 et arrière 54 sont prévues pour la commande de la couche active 58 de cristal liquide. Le substrat arrière 54 de la cellule d'affichage à cristal liquide 48 sert de substrat avant pour le réseau matriciel de diodes électroluminescentes 50 et délimite avec un second substrat arrière 64 un volume pour l'agencement d'une pluralité de couches actives 66 de diodes électroluminescentes. Une pluralité d'électrodes 68 et de contre-électrodes 70 sont disposées de part et d'autre de la couche active 66 de diodes électroluminescentes. La connexion des électrodes et contre-électrodes 60, 62 et 68, 70 à un circuit électronique de commande 72 monté sur la face arrière du système électronique est assurée au moyen de pistes conductrices 74 structurées sur les faces latérales de ce système électronique de la manière décrite ci-avant. On notera que le substrat arrière 64 du réseau matriciel de diodes électroluminescentes 50 peut être omis.

La figure 8 est une vue schématique en coupe d'un système selon l'invention comprenant une cellule d'affichage à cristal liquide 48 identique à celle décrite en liaison avec la figure 7 par exemple disposée au-dessus d'une cellule photovoltaïque 76 à forte densité de lignes. Le substrat arrière 54 de la cellule d'affichage à cristal liquide 48 sert de substrat avant pour la cellule photovoltaïque 76 et délimite avec un second substrat arrière 78 un volume pour l'agencement d'une couche active photovoltaïque 80. Une pluralité d'électrodes 82 et de contre-électrodes 84 sont disposées de part et d'autre de la couche active photovoltaïque 80. La connexion des électrodes 60, 62 et 82, 84 à un circuit électronique 86 de commande et de récupération d'énergie monté sur la face arrière du système électronique est assurée au moyen de pistes conductrices 88 structurées sur les faces latérales de ce système électronique de la manière décrite ci-dessus. On notera que le substrat arrière 78 de la cellule photovoltaïque 76 peut être omis. On notera également, à titre de variante, que la cellule photovoltaïque 76 peut être remplacée par une matrice de capteurs CMOS ou CCD.

La figure 9 est une vue schématique en coupe d'un système électronique selon l'invention comprenant une cellule d'affichage à cristal liquide 48 et un réseau matriciel de diodes électroluminescentes 50 tels qu'illustrés à la figure 7, ce montage étant complété par une cellule photovoltaïque 76 à forte densité analogue à celui représenté à la figure 8. Ces trois dispositifs électroniques sont par exemple disposés les uns au-dessus des autres et connectés à un circuit électronique de commande 90 au moyen de pistes conductrices 92 qui sont structurées sur les faces latérales du système électronique conformément aux enseignements de la présente invention.

## Revendications

1. Système électronique délimité par une face avant (34) située du côté d'un observateur, une face arrière (32) s'étendant parallèlement à la face avant et une surface latérale (42) reliant les faces avant et arrière, ce système électronique (20) comprenant au moins un dispositif électronique supérieur (36) et un dispositif électronique inférieur (40) superposés, chaque dispositif (36, 38, 40) comprenant un substrat avant et un substrat arrière (22, 24, 26, 28) s'étendant parallèlement et à distance l'un de l'autre, le substrat arrière (24) du dispositif électronique supérieur (36) pouvant être commun avec le substrat avant (26) du dispositif électronique inférieur (40), le substrat arrière du dispositif électronique inférieur pouvant être omis, le dispositif électronique supérieur (36) comprenant une première couche active (36a) disposée entre le substrat avant (22) et le substrat arrière (24), la première couche active étant commandée par au moins une première électrode et une première contre-électrode correspondante (36i) structurées sur les faces en regard des substrats avant (22) et arrière (24), la première électrode et la première contre-électrode du dispositif électronique supérieur (36) étant reliées par des premières pistes conductrices (41) à un circuit électronique de commande (30) monté sur la face arrière (32) du système électronique, la première électrode et la première contre-électrode venant affleurer à une de leurs extrémités le bord du substrat (22, 24) sur lequel elles sont structurées pour définir des premières zones latérales de contact électrique (23), les premières pistes conductrices (37) s'étendant depuis les premières zones latérales de contact électrique (23) vers la face arrière (32) du système électronique (20), le dispositif électronique inférieur (40) comprenant une deuxième couche active (40a) disposée entre le substrat avant (26) et le substrat arrière (28) du dispositif électronique inférieur (40), la deuxième couche active étant commandée par au moins une deuxième électrode et une deuxième contre-électrode correspondante (40i) structurées sur les faces en regard des substrats avant (26) et arrière (28), la deuxième électrode et la deuxième contre-électrode du dispositif électronique inférieur (40) étant reliées par des deuxièmes pistes conductrices (39) au circuit électronique de commande (30) monté à l'arrière du système électronique (20), la deuxième électrode et la deuxième contre-électrode venant affleurer à une de leurs extrémités le bord du substrat (26, 28) sur lequel elles sont structurées pour définir des deuxièmes zones latérales de contact électrique (27), les deuxièmes pistes conductrices (39) s'étendant depuis les deuxièmes zones latérales de contact électrique (27) vers la face arrière (32) du système électronique (20), les premières zones latérales de contact électrique (23) du dispositif électronique supérieur (36) étant alignées selon une direction parallèle à la direction d'alignement des deuxièmes zones latérales de contact électrique (27) du dispositif électronique inférieur (40), le système électronique (20) étant **caractérisé en ce qu'**en considérant dans le sens de gauche à droite selon les deux directions d'alignement parallèles l'une des premières zones latérales de contact électrique (23) du dispositif électronique supérieur (36) et l'une des deuxièmes zones latérales de contact électrique (37) du dispositif électronique inférieur (40) la plus proche de la première zone latérale de contact électrique (23), la première piste conductrice (37) qui relie la première zone latérale de contact électrique (23) du dispositif électronique supérieur (36) au circuit électronique de commande (30) comprend une première portion (37a) qui est adjacente à la deuxième piste conductrice (39) qui relie la deuxième zone latérale de contact électrique (27) du dispositif électronique inférieur (40) au circuit de commande (30) et qui est prolongée par une seconde portion (37b) qui s'étend au-dessous de la deuxième piste conductrice (39).

2. Système électronique selon la revendication 1, **caractérisé en ce qu'**un plot de matière conductrice (44) est déposé sur l'extrémité des électrodes à l'endroit où elles affleurent le bord du substrat sur lequel elles ont été structurées.

3. Système électronique selon l'une quelconque des revendications 1 ou 2, **caractérisé en ce que** le premier dispositif électronique est une cellule d'affichage à cristal liquide et **en ce que** le second dispositif électronique est choisi dans le groupe formé par les cellules d'affichage à cristal liquide, les réseaux matriciels de diodes électroluminescentes et les cellules photovoltaïques à fortes densités de lignes.
